# EUROPEAN PATENT APPLICATION

(11) **EP 1 876 631 A2**
(43) Date of publication of application: **09.01.2008**
(21) Application number: 06025613.8
(22) Date of filing: 11.12.2006
(51) Int. Cl.: H01J 37/20, H01J 37/26

(54) **Observational liquid/gas environment combined with specimen chamber of electron microscope**

(30) Priority: 12.06.2006 CN 200610083946
(71) Applicant: Contrel Technology Co., Ltd., Sinshin Township, Tainan County 744 (TW)
(72) Inventor: Chao, Chih-Yu, Da-An District Taipei City 106 (TW); Hsieh, Wen-Jiunn, Jhonghe City Taipei County 235 (TW)
(74) Representative: Becker Kurig Straus

(57) **Abstract**

An observational liquid/gas environment (10) combined with a specimen chamber (94) and two pole pieces (91) of an electron microscope (90) includes at least two buffer chambers (16), a plurality of spacers (11), and a gas source (15). The buffer chambers (16) are formed by the spacers (11) and the two pole pieces (91), located at an upper side and a lower side of the specimen chamber (94) respectively. The spacers (11) have inner and outer apertures (141, 161) abutting the buffer chambers (16). All of the inner and outer apertures (141, 161) are coaxially aligned with one another, crossing a path that the electron beam of the electron microscope (90) passes. The buffer chambers (16) are connected with a gas-pumping source (17). The gas source (15) is connected with the specimen chamber (94). The distance between the at least two inner apertures (141) is smaller than that of the two pole pieces (91). The spacers (11) having the inner apertures (141) are located in the specimen chamber (94) or the electron beam through tunnels (92).

## Description

### BACKGROUND OF THE INVENTION

### 1. Field of the Invention

The present invention relates generally to electron microscopes, and more particularly, to an observational liquid/gas environment combined with a specimen chamber of an electron microscope.

### 2. Description of the Related Art

According to the prior art, while an electron microscope is operated for observation of an object, the object under observation must be nonvolatile to allow observation of itself because of the limitation of the vacuum environment of the specimen chamber inside the electron microscope. For example, if a liquid or gasiform fluid matter is put into the vacuum specimen chamber, a great amount of gas will be produced to not only disable the penetration of the electron beam through the object for diffraction or imaging experiment but also to influence the vacuum of high-vacuum area, like electron gun of the electron microscope, or cause contamination inside the high-vacuum area to further damage the electron microscope.

Although Gai P. L. et al. proposed an environment inside the electron microscope for observation of liquid or gas (Gai P. L., Microscopy & Microanalysis 8, 21, 2002). However, the specimen chamber is subject to failure of effective control of amount of infused liquid to much easily incur that the liquid is too thick to enable the electron beam to penetrate the specimen. The thickness of infused liquid could be not uniform, i.e. larger liquid droplets may be formed, and also not easily controlled as expected to be electron transparent. In addition, there is one more serious problem lying in that the pressure of the specimen chamber fails to keep close to or higher than the normal atmosphere for observation. Because a great amount of vapor volatilizing from the liquid surface or the high-pressure gas injected from outside fills the whole space (gas chamber) between the two pole pieces, the multiple scattering generated by that the electron beam impinges excessive gas molecules is very serious to disable the electron beam from successful imaging and experiment of electron diffraction.

As far as I know, there is still nobody who develops any environment that is combined with the internal structure of the electron microscope for clear observation under the electron microscope.

Now, a solution to the above problem is concluded because I develop an observational liquid/gas environment combined with the specimen chamber and the two pole pieces of the electron microscope. The environment provides the liquid/gas of predetermined pressure and the thickness of the liquid/gas is thinner than that of the prior art to preferably avoid inelastic scattering under the microscopic observation, being preferably applicable to the observation under the electron microscope and the observation is preferably clear.

### SUMMARY OF THE INVENTION

The primary objective of the present invention is to provide an observational liquid/gas environment combined with a specimen chamber of an electron microscope, which provides a thinner liquid/gas environment than that of the prior art for more clear observation.

The secondary objective of the present invention is to provide an observational liquid/gas environment combined with a specimen chamber of an electron microscope, which enables an operator to control the pressure of the liquid/gas easily and greatly reduces the multiple scattering of gas molecules to further allow preferably clear observation.

The foregoing objectives of the present invention are attained by the liquid/gas environment. The electron microscope internally includes two pole pieces mounted at an inner upper side thereof and an inner lower side thereof respectively and spaced from each other for a predetermined interval, an electron beam through tunnel extending through a center of each of the pole pieces, and a specimen chamber located between the two pole pieces. The environment is combined with the specimen chamber and the two pole pieces, having at least two buffer chambers, a plurality of spacers, and a gas source. The at least two buffer chambers are formed by the spacers and the two pole pieces, located at an upper side and a lower side of the specimen chamber respectively and spaced from each other for a predetermined interval. At least one of the buffer chambers extends into the specimen chamber to overlap the specimen chamber in space. The spacer has an inner aperture located at an end of each of the buffer chambers and close to the specimen chamber, and an outer aperture thereof located at an end of each of the buffer chambers and away from the specimen chamber. All of the inner and outer apertures are coaxially aligned with one another, crossing a path that the electron beam of the electron microscope passes. Each of the buffer chambers is connected with a gas-pumping source for pumping gas. The gas source is connected with the specimen chamber for providing a gas and keeping the gas in the specimen chamber under a predetermined pressure. The distance between the at least two inner apertures is smaller than that of the two pole pieces. The spacers having the inner apertures are likely located in the specimen chamber or the electron beam through tunnels.

### BRIEF DESCRIPTION OF THE DRAWINGS

FIG 1 is a cross-sectional view of a first preferred embodiment of the present invention.
FIG 2 is another cross-sectional view of the first preferred embodiment of the present invention.
FIG 3 is a cross-sectional view of a second preferred embodiment of the present invention.
FIG 4 is another cross-sectional view of the second preferred embodiment of the present invention.
FIG 5 is another cross-sectional view of the second preferred embodiment of the present invention.
FIG 6 is a cross-sectional view of a third preferred embodiment of the present invention.
FIG. 7 is a cross-sectional view of a fourth preferred embodiment of the present invention.
FIG 8 is a cross-sectional view of a fifth preferred embodiment of the present invention.
FIG 9 is a cross-sectional view of a sixth preferred embodiment of the present invention.
FIG 10 is another cross-sectional view of the sixth preferred embodiment of the present invention.
FIG 11 is a cross-sectional view of a seventh preferred embodiment of the present invention.
FIG 12 is a cross-sectional view of an eighth preferred embodiment of the present invention.
FIG 13 is a cross-sectional view of a ninth preferred embodiment of the present invention.
FIG 14 is a cross-sectional view of a tenth preferred embodiment of the present invention.
FIG 15 is a partial schematic view of FIG 14.
FIG. 16 is a cross-sectional view of an eleventh preferred embodiment of the present invention.
FIG 17 is a cross-sectional view of a twentieth preferred embodiment of the present invention.
FIG 18 is a cross-sectional view of a thirteenth preferred embodiment of the present invention.

### DETAILED DESCRIPTION OF PREFERRED EMBODIMENTS

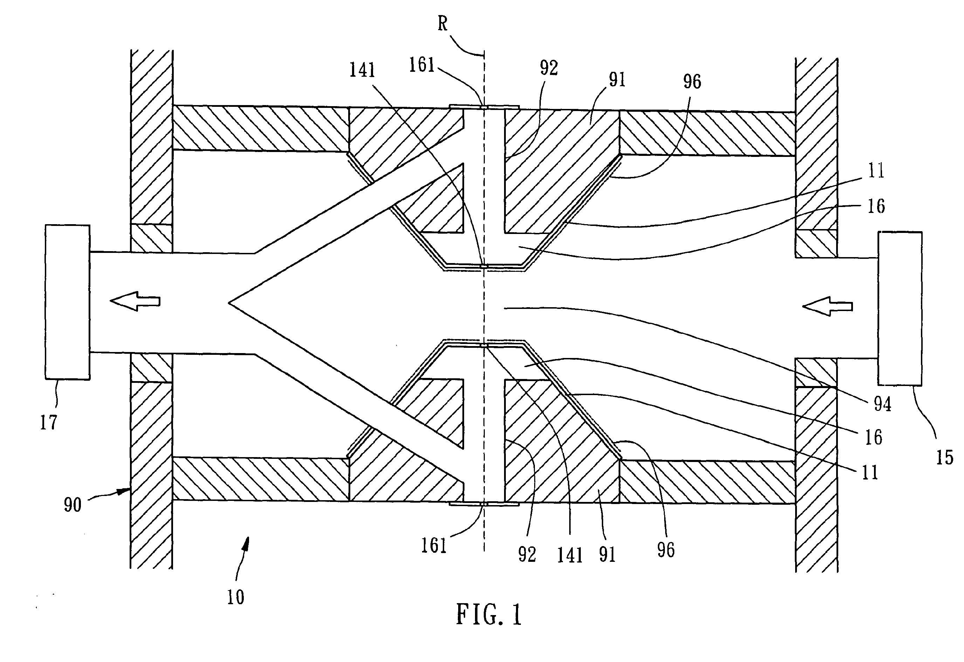

Referring to FIG 1, an observational liquid/gas environment 10 combined with a specimen chamber 94 of an electron microscope 90 is constructed according to a first preferred embodiment of the present invention. The electron microscope 90 includes two pole pieces 91 defined as an upper pole piece and a lower pole piece mounted at an inner upper side thereof and an inner lower side thereof respectively. An electron beam through tunnel 92 is formed at a center of each of the two pole pieces 91 for penetration of the electron beam. The two pole pieces 91 are spaced from each other for a predetermined interval. The specimen chamber 94 is located between the two pole pieces 91. The liquid/gas environment 10 is combined with the specimen chamber 94 and the two pole pieces 91, including two buffer chambers 16 formed by a plurality of spacers 11 and the two pole pieces 91. In this embodiment, one of the buffer chambers 16 is formed at a bottom side of the upper pole piece 91, and the other buffer chamber 16 is formed at a top side of the lower pole piece 91, such that the two buffer chambers 16 are located above and below the specimen chamber 94 respectively. The two buffer chambers 16 are spaced from each other for a predetermined interval, encapsulating the two electron through tunnels 92 and extending into the specimen chamber 94 to overlap the specimen chamber 94 in space. The spacer 11 has an inner aperture 141 located at an end of each of the buffer chambers 16 and close to the specimen chamber 94, and an outer aperture 161 thereof located at the other end of each of the buffer chambers 16 and away from the specimen chamber 94. All of the inner and outer apertures 141 and 161 are coaxially aligned with one another, crossing a path R that the electron beam of the electron microscope 90 passes. Each of the buffer chambers 16 is connected with a gas-pumping source 17 for pumping gas. A gas source 15 is connected with the specimen chamber 94 for providing a gas to keep the gas inside the specimen chamber 94 under a predetermined pressure. The distance between the two inner apertures 141 is smaller than that of the two pole pieces 91. In this embodiment, the spacers 11 having the inner apertures 141 are located in the specimen chamber 94.

While the first embodiment of the present invention is operated, the gas source 15 provides the gas for/into the specimen chamber 94 and the gas leaks through the inner apertures 141 into the buffer chambers 16. Limited to the diameter of the inner aperture 141, the gas leaking into the buffer chambers 16 is little such that the gas pressure of the buffer chambers 16 is far smaller than that of the specimen chamber 94. Besides, pumping the buffer chambers 16 with the gas-pumping source 17 can evacuate the gas from the buffer chambers 16 to prevent the gas from leaking out of the outer apertures 161. Even if a trace amount of gas leaks out of the outer apertures 161, a pumping apparatus that the electron microscope 90 has itself originally can evacuate the gas completely to keep itself vacuum. In light of this, the specimen chamber 94 can keep the gas under a predetermined pressure, and meanwhile, the electron beam can still pass through the inner and outer apertures 141 and 161. While the electron beam passes through the path R and a specimen is placed in the specimen chamber 94, the high-resolution observation can be done in the gas environment under the predetermined pressure, wherein the distance between the two inner apertures 141 is smaller than 2mm and the pressure of the gas inside the specimen chamber 94 is larger than 200 torrs. If the distance between the two inner apertures 141 is 0.7mm, the pressure of the gas inside the specimen chamber 94 can be operated to reach one atmosphere (1 atm) because the gasiform molecules, while the pressure of the gas increases, within unit volume increase and then decreasing the height of the specimen chamber 94 can decrease the gasiform molecules that the electron beam, while passing through the gasiform molecules, impinges to further improve the drawback of the imaging resolution probably resulted from the electron multiple scattering.

In addition, in the first embodiment, as shown in FIG 1, the sidewall of the specimen chamber 94, including the pole pieces 91 and surfaces of the spacers 11, is mounted with a waterproof material 96, whereby when mists are placed into the specimen chamber 94, the pole pieces 91 or the spacers 11 are prevented from rust resulted from the mists in contact therewith.

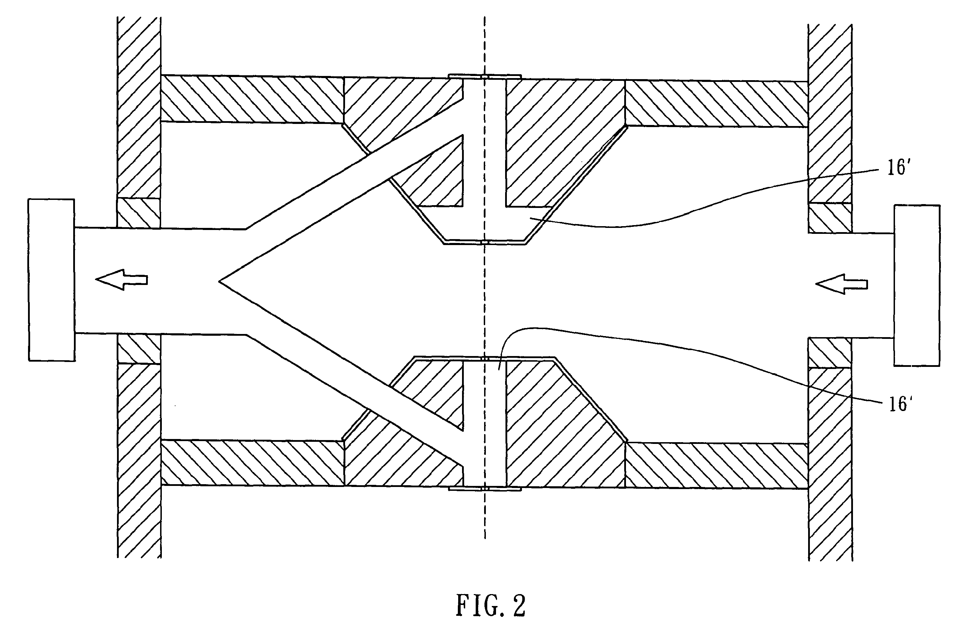

FIG 2 illustrates an alternative formation of the first embodiment after the positions of the two buffer chambers 16' are slightly changed and its structure and operational manners are the same as and equivalent to those of the first embodiment indicated in FIG 1, such that no more detailed description is necessary.

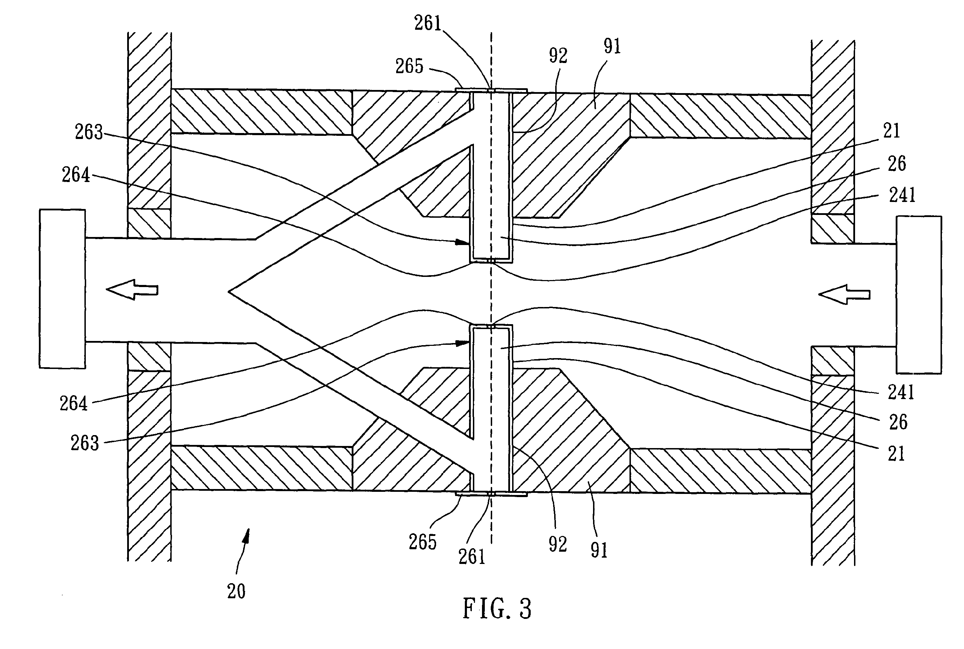

Referring to FIG 3, an observational liquid/gas environment 20 combined with the specimen chamber of the electron microscope is constructed according to a second preferred embodiment of the present invention is similar to the first embodiment but different as recited below.

A tube 263 is formed in each of the buffer chambers 26, extending toward the specimen chamber 94 from a periphery of each of the electron beam through tunnels 92 located at two opposite ends of the two pole pieces 91 for a predetermined length. Each of the tubes 263 has an inner plate 264 mounted at a distal end thereof abutting the specimen chamber 94, an inner aperture 241 formed on the inner plate 264, an outer plate 265 mounted at the other end thereof, and an outer aperture 261 formed on the outer plate 265. Each of the buffer chambers 26 is encompassed by the electron beam through tunnel 92, the tube 263, the inner plate 264, and the outer plate 265.

The way that the second embodiment of the present invention is operated is the same as that of the first embodiment, such that no more detailed description is necessary.

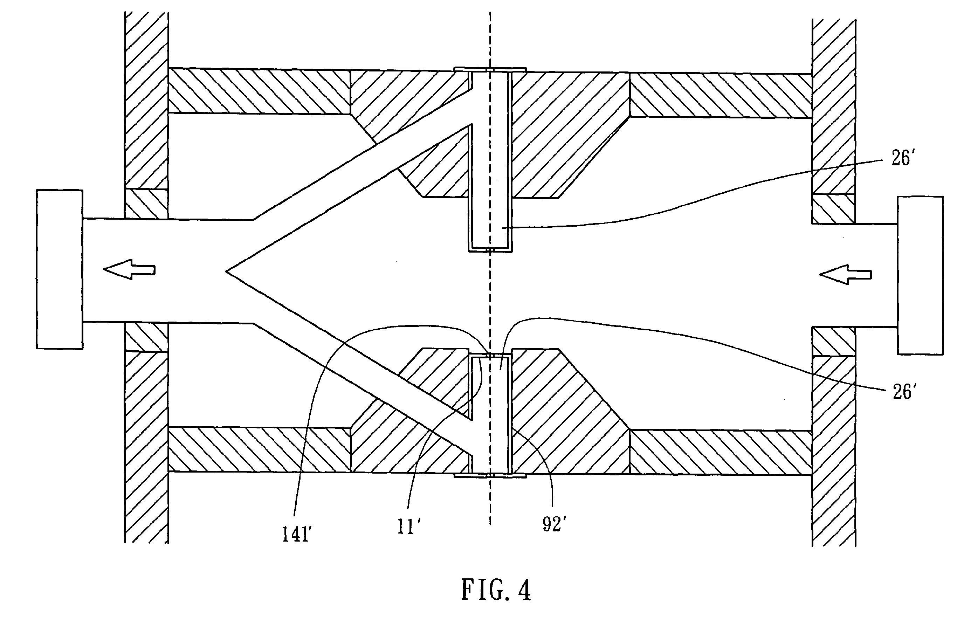

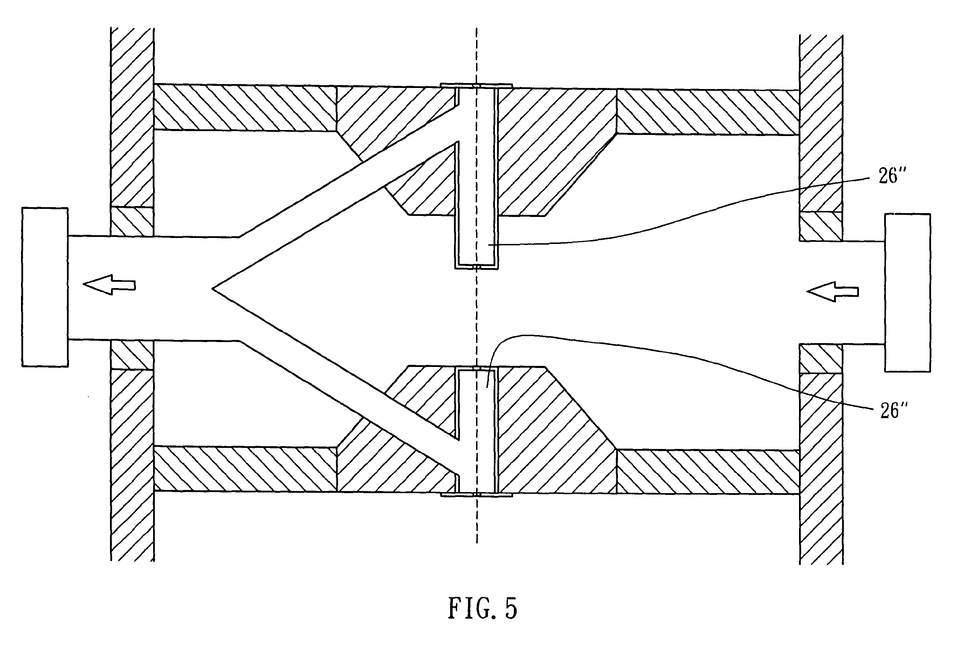

Each of FIGS. 4 and 5 illustrates an alternative formation of the second embodiment respectively after the positions of the two buffer chambers 26'(26") are slightly changed and its structure and operational manners are the same as and equivalent to those of the first embodiment indicated in FIG 1, such that no more detailed description is necessary. However, there is something important for more illustration. FIG 4 illustrates that the spacer 11' located below the specimen chamber 26' and having the inner aperture 141' is located in the electron beam through tunnel 92'.

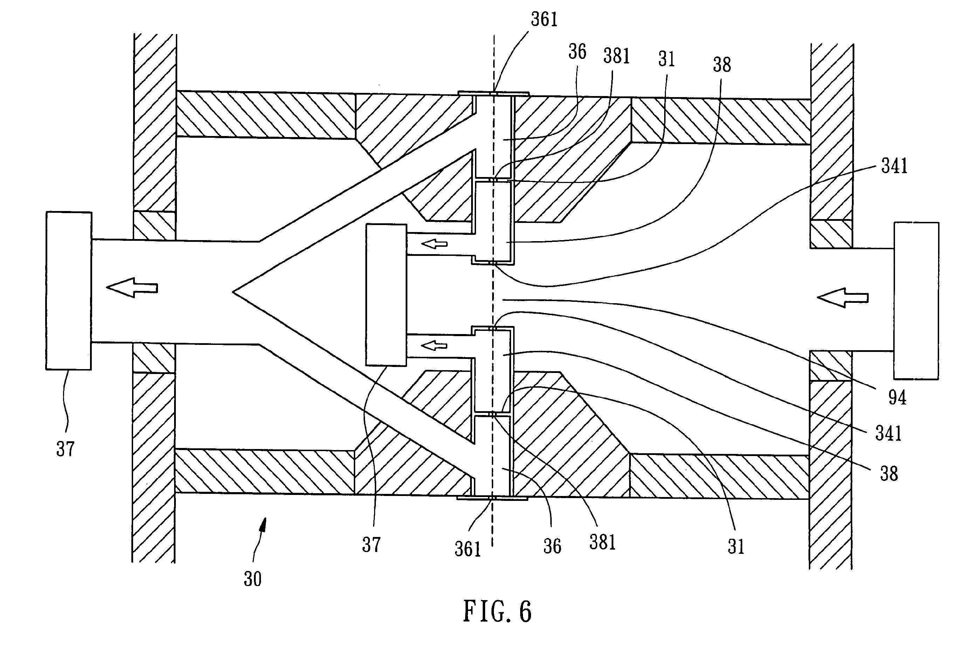

Referring to FIG 6, an observational liquid/gas environment 30 combined with the specimen chamber of the electron microscope is constructed according to a third preferred embodiment of the present invention is similar to the second embodiment but different as recited below.

The liquid/gas environment 30 further includes a spacer 31 located in each of the tubes for partitioning off each of the buffer chambers 36 to make an inner buffer chamber 38. Each of the spacers 31 includes a buffer aperture 381 located between the inner buffer chamber 38 and the buffer chamber 36. All of the buffer apertures 381, the inner apertures 341, and the outer apertures 361 are coaxially aligned with one another. The buffer chambers 36 are connected with a gas-pumping source 37 and the inner buffer chambers 38 are connected with another gas-pumping source 37.

The third embodiment includes two more buffer chambers, i.e. the two inner buffer chambers 38, than the second embodiment. Such multi-layered differential pressure pumping of this embodiment allows higher pressure of the gas inside the specimen chamber 94 and keeps the gas from leaking out of the outer apertures. The rest of the operational manners of the third embodiment are the same as those of the second embodiment, such that no more detailed description is necessary.

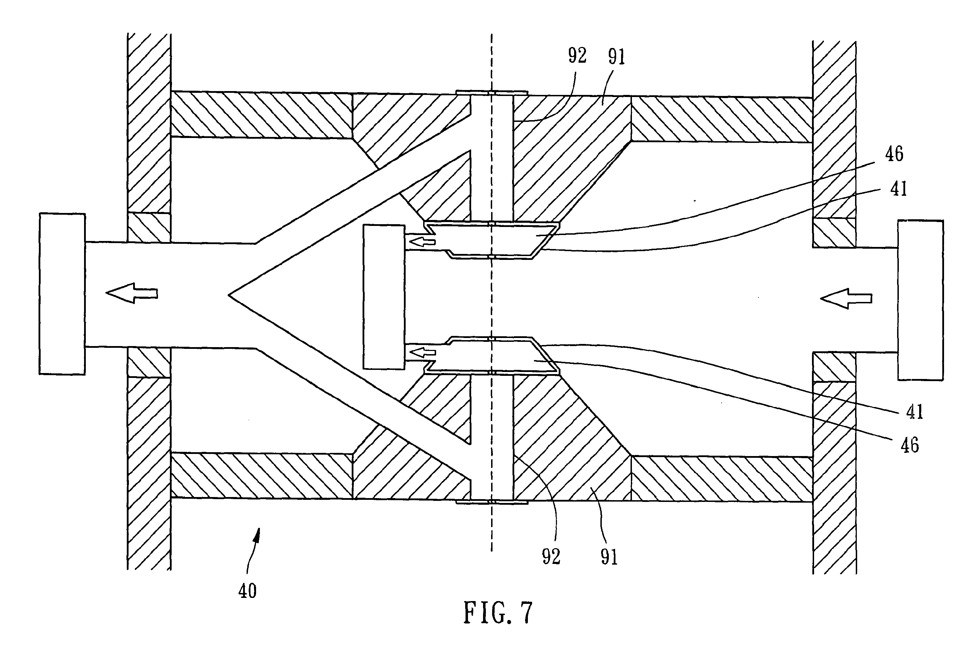

Referring to FIG 7, an observational liquid/gas environment 40 combined with the specimen chamber of the electron microscope is constructed according to a fourth preferred embodiment of the present invention is similar to the third embodiment but different as recited below.

Each of the buffer chambers 46 is encompassed to be box-like by a plurality of spacers 41, fixed to the pole piece 91, and located outside the electron beam through tunnel 92 and between the two pieces 91.

The way that the fourth embodiment of the present invention is operated is the same as that of the third embodiment, such that no more detailed description is necessary.

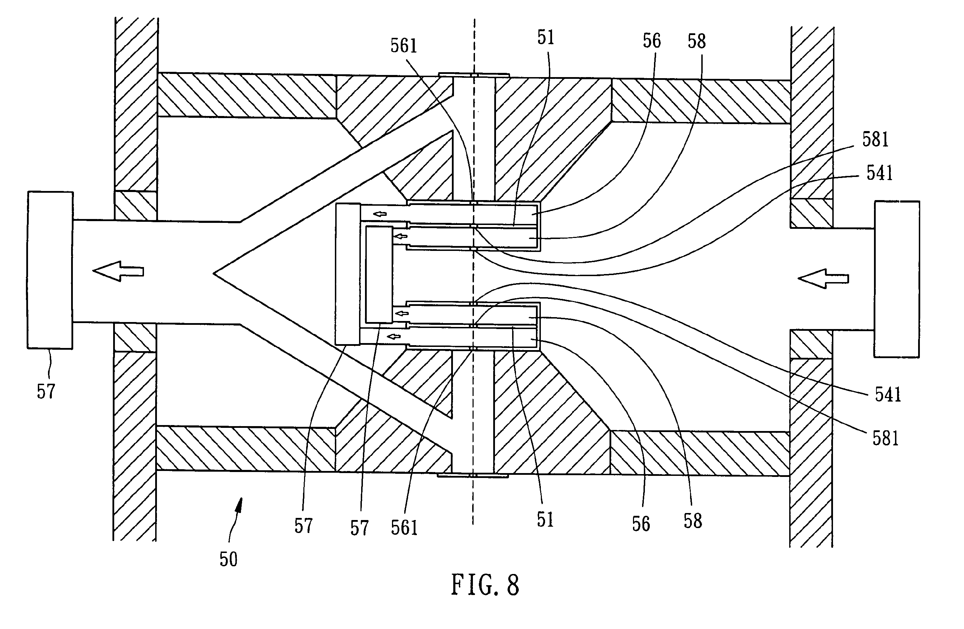

Referring to FIG 8, an observational liquid/gas environment 50 combined with the specimen chamber of the electron microscope is constructed according to a fifth preferred embodiment of the present invention is similar to the fourth embodiment but different as recited below.

Each of the buffer chambers 56 is partitioned off by a spacer 51 to make an inner buffer chamber 58 encompassed therein. The spacers 51 each between the adjacent buffer chamber 56 and the inner buffer chamber 58 each have a buffer aperture 581. The buffer apertures 581 are coaxially aligned with the inner and outer apertures 541 and 561. The buffer chambers 56 are connected with a gas-pumping source 57 and the inner buffer chambers 58 is connected with another gas-pumping source 57.

The fifth embodiment of the present invention is the same as that of the fourth embodiment in structure and operation, such that no more detailed description is necessary.

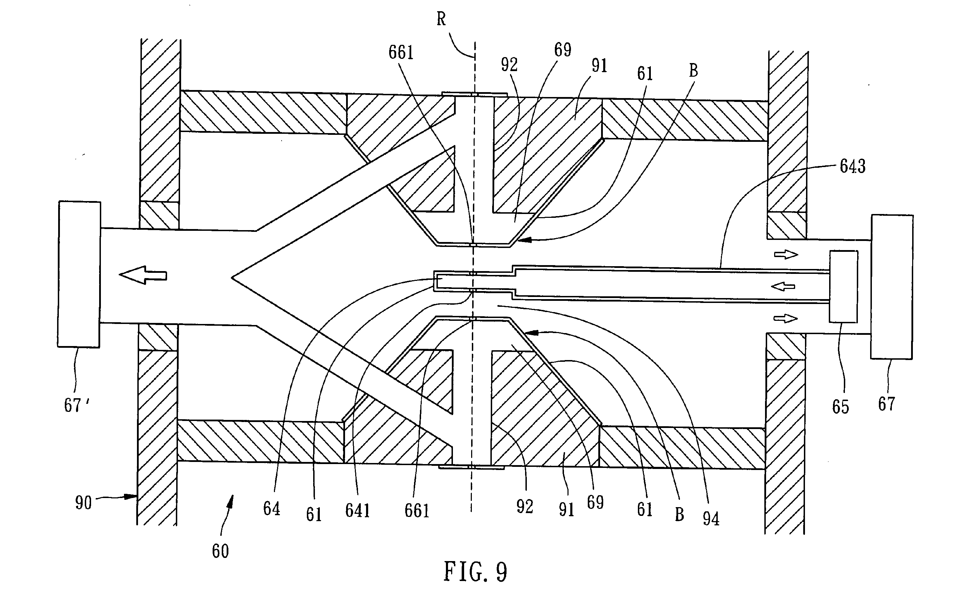

Referring to FIG 9, an observational liquid/gas environment 60 combined with the specimen chamber of the electron microscope is constructed according to a sixth preferred embodiment of the present invention. The electron microscope 90 includes two pole pieces 91 defined as an upper pole piece and a lower pole piece mounted at an inner upper side thereof and an inner lower side thereof respectively. An electron beam through tunnel 92 is formed at a center of each of the two pole pieces 91 for penetration of the electron beam. The two pole pieces 91 are spaced from each other for a predetermined interval. The specimen chamber 94 is located between the two pole pieces 91. The liquid/gas environment 60 is combined with the specimen chamber 94 and the two pole pieces 91, including a gas chamber 64.

The gas chamber 64 is encompassed by a plurality of spacers 61. The spacers 61 located at a top and bottom side of the gas chamber 64 respectively each have an inner aperture 641. The gas chamber 64 is connected with a gas source 65 and is located between the two pole pieces 91 by a support member 643 which is a specimen holder in this embodiment. The specimen chamber 94 covers the two inner apertures 641 and be connected with a pumping source 67. At least one spacer 61 is mounted on each of the pole pieces 91 to cross a path R that the electron beam passes. In this embodiment, the two pole pieces 91 and the spacer 61 located on each of the two pole pieces 91 define two boxes B respectively located in the specimen chamber 94. An outer buffer chamber 69 is formed in each of the box B, communicating with the electron beam through tunnel 92 of each of the pole pieces 91 and connected with a gas-pumping source 67' which can be a gas-pumping apparatus originally provided in the electron microscope 90 or an alternative external gas-pumping source. The spacers 61 located on the pole pieces 91 each have an outer aperture 661. The inner apertures 641 are coaxially aligned with the outer apertures 661, crossing the path R.

While the sixth embodiment is operated, the gas source 65 provides a gas for/into the gas chamber 64 and the gas leaks through the inner apertures 641 into the specimen chamber 94. Limited to the diameter of the inner aperture 641, the gas leaking into the specimen chamber 94 is very little, such that the pressure of the gas inside the specimen chamber 94 is far smaller than that of the gas chamber 64. Besides, pumping out the specimen chamber 94 with the gas-pumping source 67 can almost completely prevent the gas from leaking out of the outer apertures 661. Even if a trace amount of the gas leaks through the outer apertures 661 into the outer buffer chambers 69, the gas-pumping source 67' can pump the gas completely out of the outer buffer chambers 69 to keep it vacuum. In light of this, the gas inside the gas chamber 64 can be kept under a predetermined pressure, and meanwhile, the electron beam can still pass through the inner and outer apertures 641 and 661. When a specimen (not shown) is placed in the gas chamber 64 and located at the path R, the observation can be done in the gas environment under a predetermined pressure. Pumping out the specimen chamber 94 and outer buffer chambers 69, i.e. the multi-layered differential pressure pumping, allows the pressure of the gas inside the gas chamber 64 to reach or exceed one atmosphere and prevents the electron microscope from damage caused by the gas leaking into the electron microscope 90. In this embodiment, the height of the gas chamber 64 is defined by the distance between the two inner apertures 641. As indicated in the first embodiment, the smaller the distance of the two inner apertures 641 is, the higher the allowable pressure of the gas inside the gas chamber 64 is. What the allowable pressure can be higher does not mean that the multi-layered differential pressure pumping can improve the gas leakage but that the gas molecules increase within unit volume while the pressure of the gas inside the gas chamber 64 increases, and reduction of the height of the gas chamber 64 can decrease the gas molecules impinged by the electron beam while passing though them, further improving the drawback of the imaging resolution probably resulted from the electron multiple scattering.

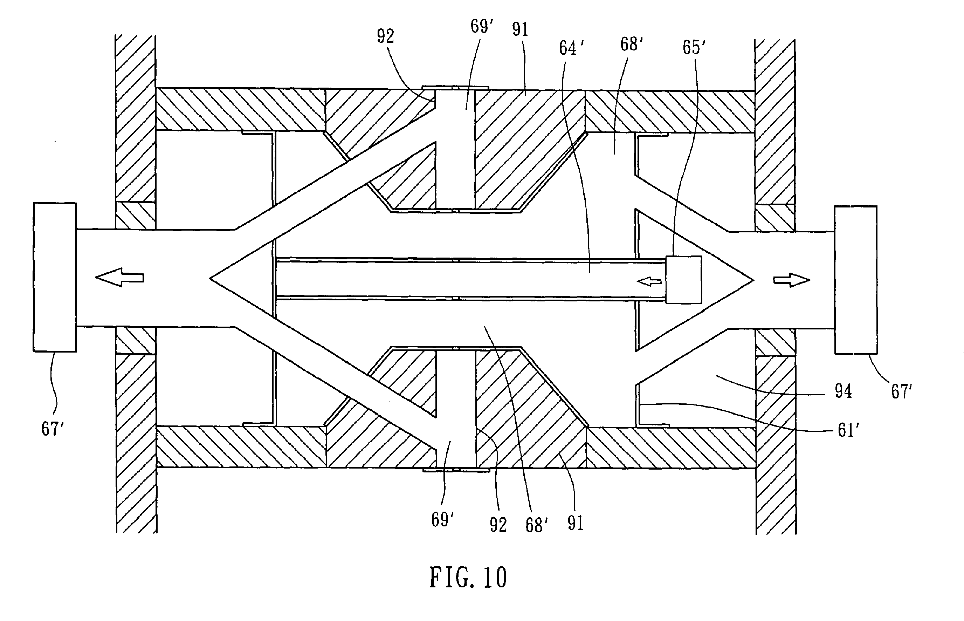

FIG 10 discloses an alternative formation of the sixth embodiment, illustrating that the gas chamber 64' is formed at a center of the specimen chamber 94, connected with a gas source 65', and supported by at least one spacer 61' mounted upright. The spacer 61' mounted on each of the pole pieces 91 is located closely to a top side of each of the pole pieces 91. Two outer buffer chambers 69' each are formed in the electron beam through tunnel 92 and encompassed by the spacer 61', connected with a gas-pumping source 67'. Two inner buffer chambers 68' each are encompassed by the gas chamber 64' and the outer buffer chamber 69', connected with another gas-pumping source 67'. In FIG 10, each of the inner buffer chambers 68' is equivalent to the specimen chamber 94' shown in FIG 9 and the rest of the structures and the operational manners are the same as and equivalent to those of FIG 9, such that no more detailed recitation is necessary.

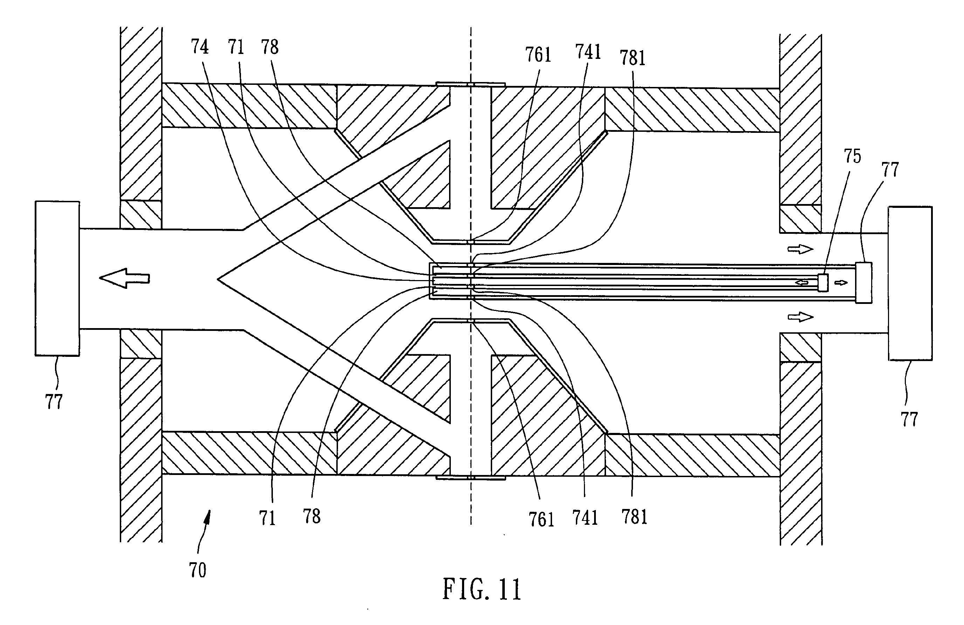

Referring to FIG 11, an observational liquid/gas environment 70 combined with the specimen chamber of the electron microscope is constructed according to a seventh preferred embodiment of the present invention is similar to the sixth embodiment but different as recited below.

The gas chamber 74 is further partitioned off by a plurality of spacers 71 to make two inner buffer chambers 78 located above and below the gas chamber 74. Each of the spacers 71 located between the two inner buffer chambers 78 and the gas chambers 74 includes a buffer aperture 781 for communication with the inner buffer chamber 78 and the gas chamber 74. All of the buffer, inner, and outer apertures 781, 741, and 761 are coaxially aligned with one another. The two inner buffer chambers 78 are connected with a gas-pumping source 77. The gas chamber 74 is connected with a gas source 75.

The seventh embodiment is structurally similar to the sixth embodiment, further including two inner buffer chambers 78 to employ the multi-layered differential pressure pumping to allow the higher pressure of the gas inside the gas chamber 74 as the same as the third embodiment does. The rest of the operational manners are the same as the sixth embodiment, such that no more detailed description is necessary.

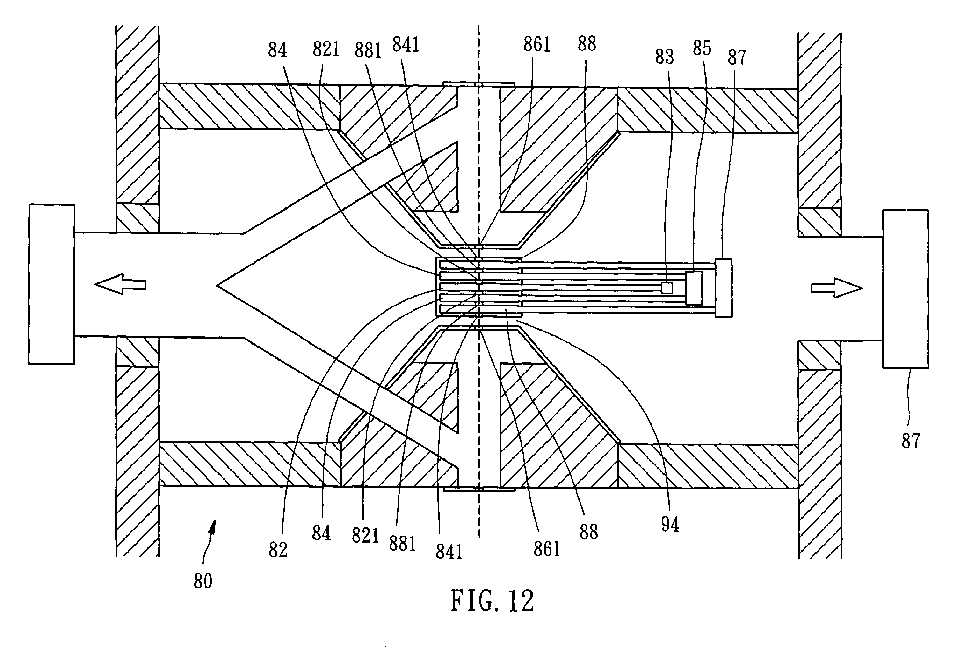

Referring to FIG 12, an observational liquid/gas environment 80 combined with the specimen chamber of the electron microscope is constructed according to an eighth preferred embodiment of the present invention is similar to the seventh embodiment but different as recited below.

The gas chamber 84 is further partitioned off by a plurality of spacers 81 to make a liquid chamber 82 connected with a liquid source 83, encapsulating a top and bottom side of the liquid chamber 82. Two gas apertures 821 each are formed on the spacer 81 and located at the top and bottom sides of the liquid chamber 82. All of the gas, inner, buffer, and outer apertures 821, 841, 881, and 861 are coaxially aligned with one another.

The liquid chamber 82 contains a liquid which is very thin to allow penetration of the electron beam of the electron microscope through itself without generation of mass inelastic scattering. The gas apertures 821 each must have a very small diameter to disable the liquid from leakage but to merely enable the liquid to volatilize out of the gas apertures 821 and then leak outward into the gas chamber 84. The gas source 85 is employed to provide the gas chamber 84 with vapor of a predetermined pressure to further suppress the liquid inside the liquid chamber 82 from volatilization out of the gas apertures 821. In the meantime, each of the gas-pumping sources 87 is employed to pump out the inner buffer chamber 88 and the specimen chamber 94. In light of this, a layer of the liquid is maintained in the liquid chamber 82 to provide an observational liquid environment.

The rest of operational statuses of the eighth embodiment are the same as those of the seventh embodiment, such that no more detailed recitation is necessary.

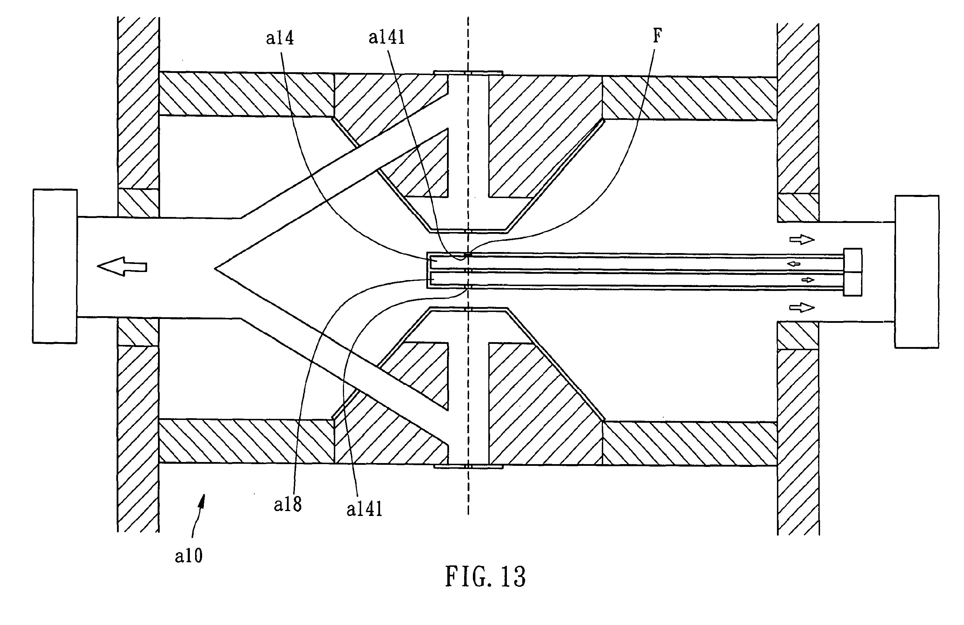

Referring to FIG 13, an observational liquid/gas environment a10 combined with the specimen chamber of the electron microscope is constructed according to a ninth preferred embodiment of the present invention is similar to the seventh embodiment but different as recited below.

One of the two inner apertures a141, located above the other, is sealed with a film F. The film F is very thin, substantially 20-50nm, to allow penetration of the electron beam of the electron microscope and to prevent the gas inside the gas chamber a14 from leakage but to enable the gas to leak out of the other inner aperture a141 . Because of the film F, the gas cannot pass through the inner aperture a141 located above the other and thus it is not necessary to mount an inner buffer chamber a18 above the gas chamber a14. In light of this, it is sufficient and unsymmetrical to mount only one inner buffer chamber a18 below the gas chamber a14.

The rest of the structures and operational manners of the ninth embodiment are the same as those of the seventh embodiment, such that no more detailed description is necessary.

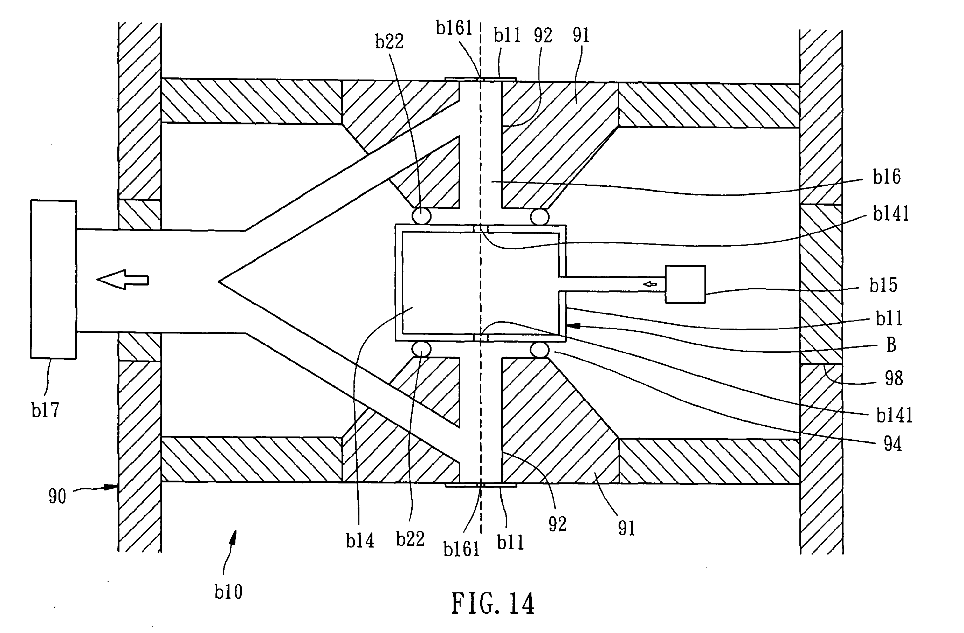

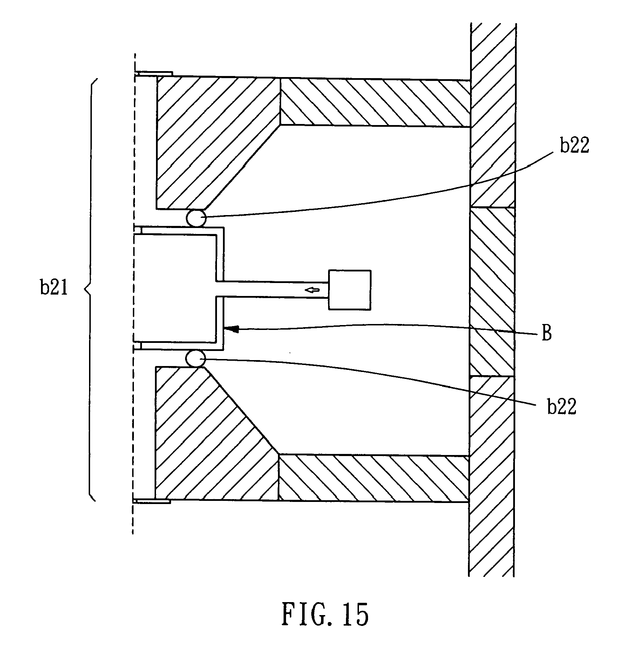

Referring to FIGS. 14 and 15, an observational liquid/gas environment b10 combined with the specimen chamber of the electron microscope is constructed according to a tenth preferred embodiment of the present invention. The electron microscope 90 includes two pole pieces 91 defined as an upper pole piece and a lower pole piece mounted at an inner upper side thereof and an inner lower side thereof respectively. An electron beam through tunnel 92 is formed at a center of each of the two pole pieces 91 for penetration of the electron beam. The two pole pieces 91 are spaced from each other for a predetermined interval. The specimen chamber 94 is located between the two pole pieces 91. The liquid/gas environment b10 is combined with the specimen chamber 94 and the two pole pieces 91, including a plurality of spacers b11.

The spacers b11 are mounted between the two pole pieces 91 and at a top side of the upper pole piece 91 and a bottom side of the lower pole piece 91 respectively to define an elongated subspace b21 in a space composed of the electron beam through tunnels 92 and the specimen chamber 94. The elongated subspace b21 is partitioned into a gas chamber b 14 and at least one buffer chamber b 16. The gas chamber b 14 is formed in an independent box B encompassed by the spacers b11 and separable from the elongated subspace b21. Two inner apertures b141 are formed on the spacers b11 located at a top side and a bottom side of the gas chamber b14 respectively. The buffer chamber b16 can be diversely formed, wherein one of the diverse formations (not shown) is that the buffer chamber b16 completely encapsulates the gas chamber b14 to cover the two inner apertures b141, working as one small cup and one large cup are fitted to each other. In this embodiment, the two buffer chambers b16 are formed above and below the gas chamber b14 to cover the two inner apertures b141 and located in the electron beam through tunnels 92. The spacers b11 located at a top side of the upper pole piece 91 and a bottom side of the lower pole piece 91 respectively each have an outer aperture b161. The gas chamber b 14 is connected with a gas source b15. The two buffer chambers b 16 are connected with a gas-pumping source b17. A plurality of sealing members b22 are mounted closely between the box B and the two pole pieces 91, each being an O-ring in this embodiment. As shown in FIG 14, the sealing members b22 are located at a bottom side of the upper pole piece 91 and a top side of the lower pole piece 91 respectively to keep what is between the elongated subspace b21 and the specimen chamber 94 located outside the elongated subspace b21 airtight.

In operation, the tenth embodiment employs the gas source b15 to provide the gas for/into the gas chamber b14 and employs the buffer chambers b 16 for gas evacuation. The rest of the operation manners are the same as those of the first embodiment, such that no more detailed description is necessary.

Further, when the tenth embodiment is actually used, the sealing members b22 can be fitted onto the box B first, and then laterally insert the combination of the sealing members b22 and the box B through an insertion port 98 originally provided at a lateral side of the specimen chamber 94 of the electron microscope 90 into the specimen chamber 94. After the insertion of the combination, the sealing members b22 closely contact against the two pole pieces 91 respectively, and the two buffer chambers b16 and the gas chamber b14 are incorporated to form the elongated subspace b21 and to be separated from and without communication with the specimen chamber 94. Such lateral insertion is very convenient and enables the combination of the sealing members b22 and the box B to be independently located in the elongated subspace b21 of the specimen chamber 94 without alteration of the original design of the electron microscope 91.

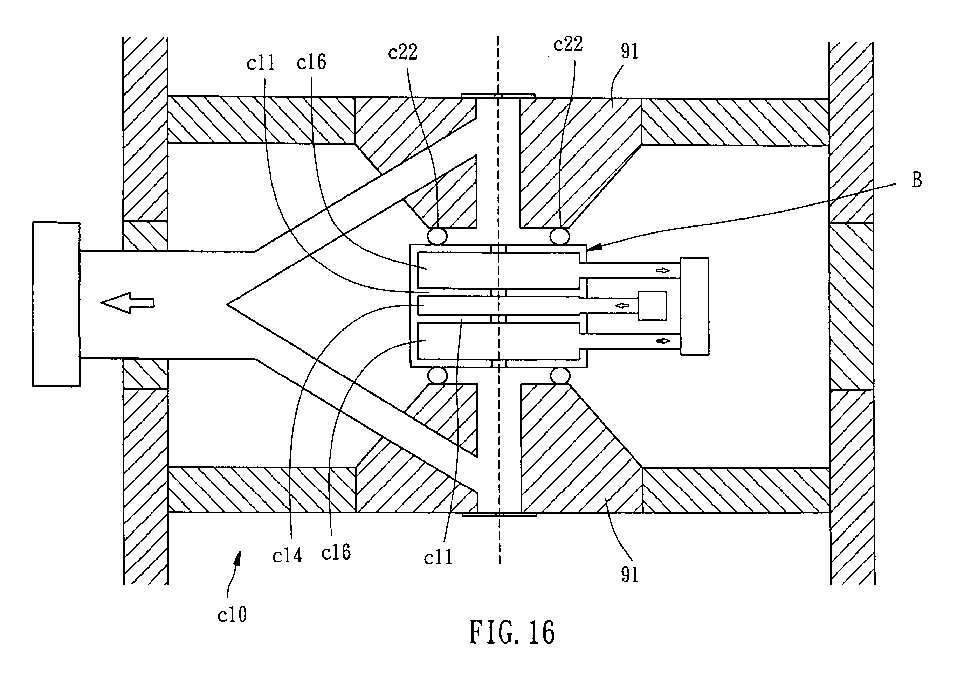

Referring to FIG 16, an observational liquid/gas environment c10 combined with the specimen chamber of the electron microscope is constructed according to an eleventh preferred embodiment of the present invention is similar to the tenth embodiment but different as recited below.

The gas chamber c14 and the two buffer chambers c16 are formed in a box B independently located in the specimen chamber 94. Since the rest of the structures, e.g. the sealing members c22 are located between the box B and the two pole pieces 91, and the operational manners are the same as those of the tenth embodiment, no more detailed description is necessary.

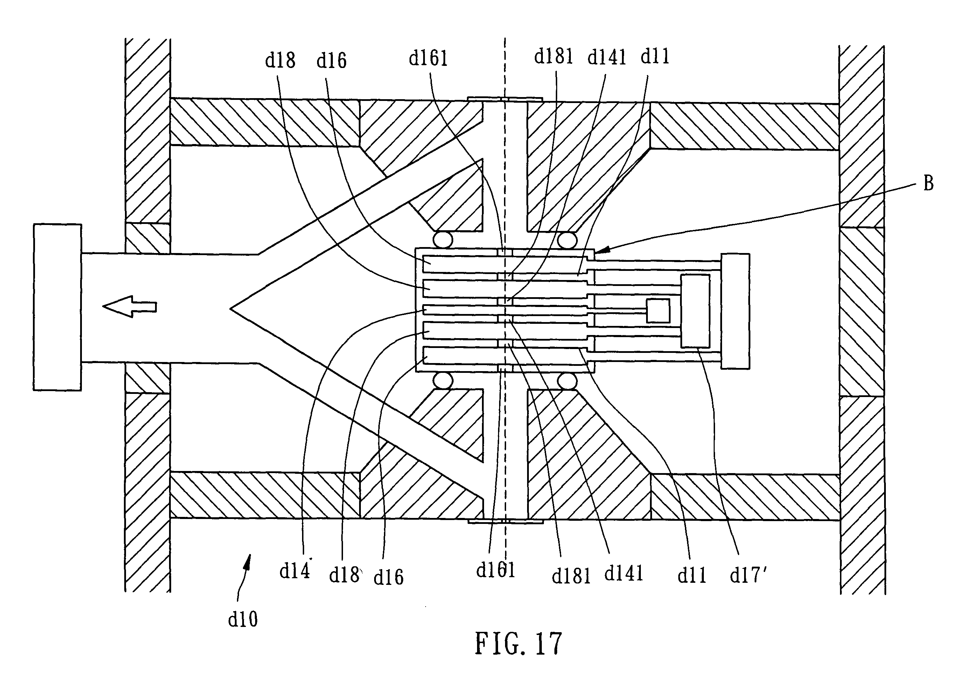

Referring to FIG 17, an observational liquid/gas environment d10 combined with the specimen chamber of the electron microscope is constructed according to a twelfth preferred embodiment of the present invention is similar to the eleventh embodiment but different as recited below.

Two inner buffer chambers d 18 are formed between the two buffer chambers d16 and the gas chamber d14 and in an independent box B. The spacer d11 located between each of the inner buffer chambers d18 and each of the buffer chambers d16 includes a buffer aperture d181. All of the inner, buffer, and outer apertures d141, d181, and d161 are coaxially aligned with one another. The inner buffer chambers d18 are connected with a second gas-pumping source d17'.

The twelfth embodiment has two more buffer chambers than the eleventh embodiment, employing the multi-layered differential pressure pumping, as the third embodiment does, to allow higher pressure of the gas inside the gas chamber d14. The rest of the operational manners are the same as those of the eleventh embodiment, such that no more detailed description is necessary.

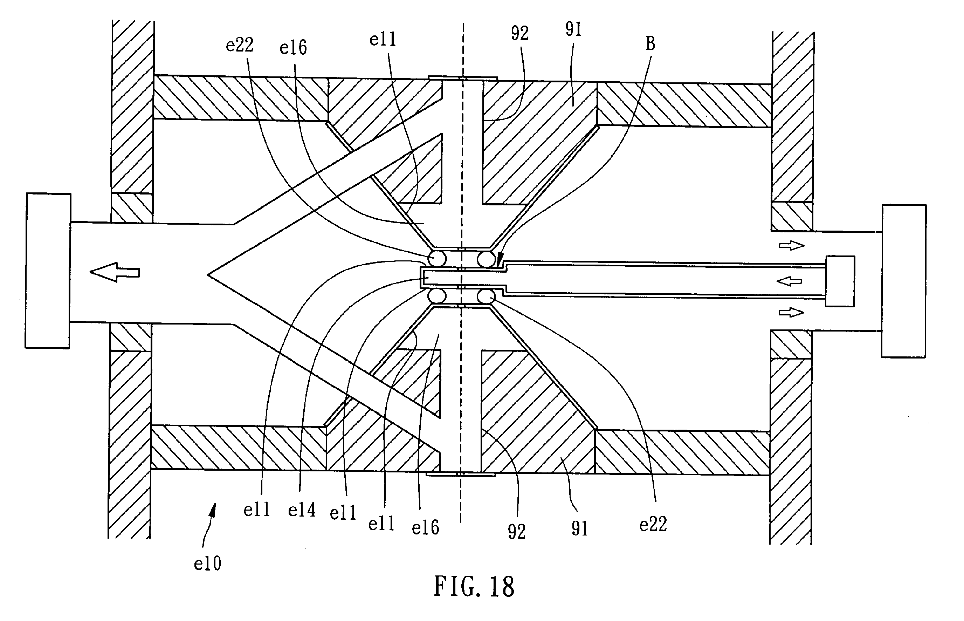

Referring to FIG. 18, an observational liquid/gas environment e10 combined with the specimen chamber of the electron microscope is constructed according to a thirteenth preferred embodiment of the present invention is similar to the tenth embodiment but different as recited below.

The gas chamber e14 is formed in an independent box B. The two buffer chambers e16 are formed outside the electron beam through tunnels 92 of the pole pieces 91 respectively and located between the two pole pieces 91. The sealing members e22 are located between the box B and the spacers e11 abutting the two buffer chambers e16.

The gas chamber in the box of the thirteenth embodiment is thinner than that of the tenth embodiment and easier for high-resolution observation. The rest of the operational manners are the same as those of the tenth embodiment, such that no more detailed description is necessary.

In addition to the aforementioned embodiments, the present invention having the core technical feature (the gas and buffer chambers in cooperation with the space inside the two pole pieces 90 and the specimen chamber 94 of the electron microscope) includes various other equivalent embodiments, e.g. the liquid chamber of the eighth embodiment can be changed to the gas chamber to enable two buffer chambers to be located above and below the gas chamber; an additional buffer chamber can be alternatively mounted outside the inner buffer chambers to enable the differential pressure pumping of more layers to allow higher pressure of the gas inside the gas chamber; or the box that the gas chamber of the tenth embodiment is located is formed on a specimen holder to have better operational convenience.

In conclusion, the present invention includes the following advantages.

### 1. Thinner liquid/gas observational environment

The present invention combines the specimen chamber and the pole pieces for penetration of the electron beam through for observation. The thinner gas observational environment of the present invention than the prior art preferably prevents the observation from the inelastic scattering and to enable clearer observation. In addition, the present invention is capable of creating an observational environment of ultra-thin liquid to do the observation of live cell, bacteria, virus, medicine, chemical reaction, etc.

### 2. Easier for control

The present invention can create a thinner liquid/gas observational environment than the prior art and enable larger range that the pressure of the gas/liquid inside the observational environment is operable. In other words, the environment of the present invention allows higher pressure of the gas existing in the gas chamber and then likewise enables clear observation.

Although the present invention has been described with respect to specific preferred embodiments thereof, it is no way limited to the details of the illustrated structures but changes and modifications may be made within the scope of the appended claims.

## Claims

1. An observational liquid/gas environment (10) combined with a specimen chamber (94) of an electron microscope (90), said electron microscope (90) having two pole pieces (91) defined as an upper pole piece and a lower pole piece mounted at an inner upper side thereof and an inner lower side thereof respectively, an electron beam through tunnel (92) being formed at a center of each of said two pole pieces (91) for penetration of said electron beam, said two pole pieces (91) being spaced from each other for a predetermined interval, said specimen chamber (94) being located between said two pole pieces (91), **characterized in that** said environment comprises:
at least two buffer chambers (16) formed by a plurality of spacers (11) in cooperation with said two pole pieces (91), said buffer chambers (16) being located at an upper side and a lower side of said specimen chamber (94) respectively and spaced from each other for a predetermined interval, one of said buffer chambers (16) extending into and overlapping said specimen chamber (94) in space, said spacer (11) having an inner aperture (141) located at an end of each of said buffer chambers (16) and close to said specimen chamber (94), said spacer (11) having an outer aperture (161) located at an end of each of said buffer chambers (16) and away from said specimen chamber (94), said inner and outer apertures (161) being coaxially aligned with one another and crossing a path that said electron beam of said electron microscope (90) passes, each of said buffer chambers (16) being connected with a gas-pumping source (17); and
a gas source (15) connected with said specimen chamber (94) for providing a gas and keeping a predetermined gas pressure of said specimen chamber (94);
wherein the distance between said inner apertures (141) is smaller than that of said two pole pieces (91), and said spacers (11) having said inner apertures (141) are located in said specimen chamber (94) or said electron beam through tunnel (92).

2. The environment (10) as defined in claim 1 further comprising a buffer chamber (16) formed on each of said pole pieces (91) by said spacers (11).

3. The environment (10) as defined in claim 2, wherein each of said buffer chambers (16) encapsulates said electron beam through tunnel (92) of said pole piece (91).

4. The environment (20) as defined in claim 3 further comprising a tube (263) extending toward said specimen chamber (94) from a periphery of each of said electron beam through tunnels (92) located at two opposite ends of the two pole pieces (91) for a predetermined length, wherein said tubes (263) each have an inner plate (264) formed at a distal end thereof and an outer plate (265) thereof formed at the other end thereof; said inner apertures (241) are formed on said inner plates (264); said outer apertures (261) are formed on said outer plates (265); each of said buffer chambers (26) is encompassed by said electron beam through tunnel (92), said tube (263), and said inner plate (264).

5. The environment (30) as defined in claim 4, wherein each of said buffer chambers (36) is further partitioned off by a spacer (31) to make an inner buffer chamber (38), said spacers (31) each between said buffer chamber (36) and said inner buffer chamber (38) each having a buffer aperture (381), said buffer aperture (381) being coaxially aligned with said inner and said outer apertures (341, 361), said buffer chambers (36) being connected with a gas-pumping source (37), said inner buffer chambers (38) being connected with another gas-pumping source (37).

6. The environment (10) as defined in claim 2, wherein each of said buffer chambers (16) is located outside said electron beam through tunnel (92) of said pole piece (91) and between said two pole pieces (91).

7. The environment (10) as defined in claim 6, wherein each of said buffer chambers (16) is fixed onto said pole piece (91) and encompassed by a plurality of spacers (11) to be box-like.

8. The environment (30) as defined in claim 7, wherein each of said buffer chambers (16) is partitioned off by a spacer (31) and its sidewall to make an inner buffer chamber (38), said spacers (31) each between said buffer chamber (36) and said inner buffer chamber (38) each having a buffer aperture (381), said buffer apertures (381) being coaxially aligned with said inner and outer apertures (341, 361), said buffer chambers (36) being connected with a gas-pumping source (37), said inner buffer chambers (38) being connected with another gas-pumping source (37).

9. The environment (10) as defined in claim 1, wherein said specimen chamber (94) is provided with a sidewall including said pole pieces (91) and surfaces of said spacers (11), said sidewall of said specimen chamber (94) being made of waterproof material.

10. The environment (10) as defined in claim 1, wherein when the observation is done under the electron microscope (90) in high resolution, the distance between said two inner apertures (141) is smaller than 2mm and the pressure of the gas inside the specimen chamber (94) is larger than 200 torrs.

11. An observational liquid/gas environment (60) combined with a specimen chamber (94) of an electron microscope (90), said electron microscope (90) having two pole pieces (91) defined as an upper pole piece and a lower pole piece mounted at an inner upper side thereof and an inner lower side thereof respectively, an electron beam through tunnel (92) being formed at a center of each of said two pole pieces (91) for penetration of said electron beam, said two pole pieces (91) being spaced from each other for a predetermined interval, said specimen chamber (94) being located between said two pole pieces (91), **characterized in that** said environment (10) comprises:
a gas chamber (64) encompassed by a plurality of spacers (61), wherein said spacers (61) located at a top side and a bottom side of said gas chamber (64) each have an inner aperture (641), and said gas chamber (64) is connected with a gas source (65) and supported by a support member (643) and located between said two pole pieces (91);
wherein said specimen chamber (94) encapsulates said two inner apertures (641) and connected with a gas-pumping source (67); at least one of said spacers (61) provided on each of said pole pieces (91) crosses a path that said electron beam passes, said at least one spacer (61) having an outer aperture (661) formed thereon, said inner and outer apertures (641, 661) being coaxially aligned with one another and crossing said path.

12. The environment (60) as defined in claim 11, wherein said at least one spacer (61) provided on each of said pole pieces (91) and each of said pole pieces (91) together define a box (B), said two boxes (B) each having an outer buffer chamber (69) formed therein and connected with a gas-pumping source (67').

13. The environment (70) as defined in claim 11, wherein said gas chamber (74) is further partitioned off by at least one spacer (71) to make at least one inner buffer chamber (78), said spacer (71) located between said gas chamber (74) and said inner buffer chamber (78) having a buffer aperture (781), said inner buffer chamber (78) being connected with a gas-pumping source (77), said buffer, inner, and outer apertures (781, 741, 761) being coaxially aligned with one another.

14. The environment (80) as defined in claim 13, wherein said gas chamber (84) is further partitioned off by at least one spacer (81) to make a liquid chamber (82) connected with a liquid source (83), said gas chamber (84) encapsulating a top and bottom side of said liquid chamber (83), said spacers (81) located at the top and bottom sides of the liquid chamber (82) each having a gas aperture (821) coaxially aligned with said inner, buffer, and outer apertures (841, 881, 861).

15. The environment (a10) as defined in claim 11, wherein one of said two inner apertures (a141) is sealed with a film (F).

16. An observational liquid/gas environment (b10) combined with a specimen chamber (94) of an electron microscope (90), said electron microscope (90) having two pole pieces (91) defined as an upper pole piece and a lower pole piece mounted at an inner upper side thereof and an inner lower side thereof respectively, an electron beam through tunnel (92) being formed at a center of each of said two pole pieces (91) for penetration of said electron beam, said two pole pieces (91) being spaced from each other for a predetermined interval, said specimen chamber (94) being located between said two pole pieces (91), **characterized in that** said environment (b10) comprises:
a plurality of spacers (b11) mounted between said two pole pieces (91) and defining an elongated subspace (b21) in a space formed by the combination of said electron through tunnels (92) of said pole pieces (91) and said specimen chamber (94), said elongated space (b21) being partitioned into a gas chamber (b14) and at least one buffer chamber (b16), said spacers (b11) located at a top and bottom side of said gas chamber (b14) each having an inner aperture (b141), said buffer chamber (b16) encapsulating said two inner apertures (b141), said spacers (b11) located at a top and bottom side of said buffer chamber (b16) each having an outer aperture (b161), said gas chamber (b14) being connected with a gas source (b15), said buffer chamber (b16) being connected with a gas-pumping source (b 17);
wherein said gas chamber (b14) is separable from said elongated subspace (b21), and a plurality of sealing members (b22) are mounted to seal between said gas chamber (b14) and said elongated subspace (b21).

17. The environment (b10) as defined in claim 16 further comprising two buffer chambers (b16) formed above and below said gas chamber (b14) respectively.

18. The environment (b10) as defined in claim 17, wherein said gas chamber (b14) is formed in an independent box (B); said two buffer chambers (b16) are formed at said two pole pieces (91) and located in said electron beam through tunnels (92) respectively; said sealing members (b22) are located between said box (B) and said two pole pieces (91).

19. The environment (c10) as defined in claim 17, wherein said gas chamber (c14) and said two buffer chambers (c16) are formed in a box (B) formed independently; said sealing members (c22) are located between said box (B) and said two pole pieces (91).

20. The environment (d10) as defined in claim 17 further comprising two inner buffer chambers (d18) formed between said two buffer chambers (d16) and said gas chamber (d14) respectively, wherein said spacers (d11) each located between said inner buffer chamber (d18) and said buffer chamber (d16), which are adjacent to each other, each have an buffer aperture (d181), said inner, buffer, and outer apertures (d141, d181, 161) being coaxially aligned with one another, each of said inner buffer chambers (d18) being connected with a second gas-pumping source (d17').

21. The environment (d10) as defined in claim 20, wherein said gas chamber (d14), said two buffer chambers (d16), and said two inner buffer chambers (d18) are formed in an independent box (B); said sealing members (c22) are located between said box (B) and said two pole pieces (91).

22. The environment as defined in claim 18 or 19 or 21, wherein said sealing members (b22) are located at a bottom side of said upper pole piece (91) and a top side of said lower pole piece (91) respectively.

23. The environment as defined in claim 17, wherein said gas chamber (b14) is formed in an independent box (B); said two buffer chambers (e16) are formed outside said electron beam through tunnels (92) of said two pole pieces (91) and between said two pole pieces (91); said sealing members (e22) are located between said box (B) and said spacers (e11) abutting said box (B).

24. The environment (b10) as defined in claim 16, wherein each of said sealing members (b22) is an O-ring.
